# EUROPEAN PATENT SPECIFICATION

(11) **EP 0 527 133 B1**
(45) Date of publication and mention of the grant of the patent: **27.12.1995**
(21) Application number: 91903485.0
(22) Date of filing: 09.10.1990
(51) Int. Cl.: H01J 37/32, H01L 21/302

(54) **PLASMA REACTION CHAMBER HAVING CONDUCTIVE DIAMOND-COATED SURFACES**
PLASMA-REAKTIONSKAMMER MIT LEITENDEN DIAMANT-BESCHICHTETEN OBERFLÄCHEN
CHAMBRE DE REACTION PLASMATIQUE AYANT DES SURFACES A REVETEMENT EN DIAMANT CONDUCTEUR

(30) Priority: 30.04.1990 US 516505
(43) Date of publication of application: 17.02.1993
(73) Proprietor: International Business Machines Corporation, Armonk, N.Y. 10504 (US)
(72) Inventor: DOWNEY, Douglas, John, Austin, TX 78741 (US); LIPORACE, James, William, Wallkill, NY 12589 (US)
(74) Representative: Siccardi, Louis
(86) International application number: US9005767
(87) International publication number: WO9117562

(56) References cited:
- EP-A- 0 140 975
- EP-A- 0 364 215

## Description

### Background of the Invention

### Field of the Invention

The present invention generally relates to semiconductor device manufacturing tools having plasma reaction chambers and, more particularly, to such chambers having diamond-coated surfaces to prevent sputtering of the chamber surfaces and to stop concomitant contamination of the semiconductor device workpiece therein.

### Description of the Related Art

As described in U.S. patent 4,657,617, issued on April 14, 1987 to Randall E. Johnson et al. for Anodized Aluminum Substrate for Plasma Etch Reactor, the gas plasmas typically used in semiconductor device etching tools react with tool surfaces and corrode the same as well as release some surface particles which may contaminate the semiconductor workpiece. Attempts have been made to protect some tool surfaces against such corrosion and to prevent undesirable contamination of the device being fabricated. Said patent teaches that the anodization of an aluminum wafer substrate assembly exposed to the plasma would protect those substrate surfaces from damaging corrosion. The improvement afforded by tool anodization, however, is wanting in the context of constantly evolving state-of-the-art semiconductor devices having greater densities and smaller geometries where sensitivity to contaminants becomes increasingly critical.

One of the requirements of the walls of the plasma reaction chamber is to have electrically conductive properties so that they may be used as an electrical ground in the plasma reaction process. Insulating materials per se, such as anodized aluminum, therefor cannot be used for protectively coating those tool surfaces that must remain conductive.

### Summary of the Invention

An object of the present invention is to substantially reduce reaction between the plasma and the chamber walls of a plasma reaction chamber.

Another object is to prevent sputtering of the chamber walls of tools used in reactive ion etching processes.

A further object is to prevent contamination of semiconductor workpieces due to reaction of the plasma and the chamber walls of a reactive ion etching tool.

Another object is to place an electrically conductive but nonreacting coating on the surfaces of semiconductor device tools exposed to plasma.

These objects are achieved by a reactive ion etching apparatus according to claim 1.

In accordance with the present invention, the sputtering of the chamber walls of tools used in the reactive ion etching of semiconductor devices is prevented by coating the walls with a conductive diamond layer. The diamond layer is formed using known processes such as chemical vapor (CVD), ion bombardment or ion beam expitaxial deposition processes. Suitable conductivity is imparted to the diamond layer by control of CVD deposition process parameters whereby predetermined amounts of graphite are introduced into the diamond or by the use of conductive dopants. The conductive properties so created do not impact the desired hardness, inertness and strength of the diamond layer because the required amount of non-diamond material is minute.

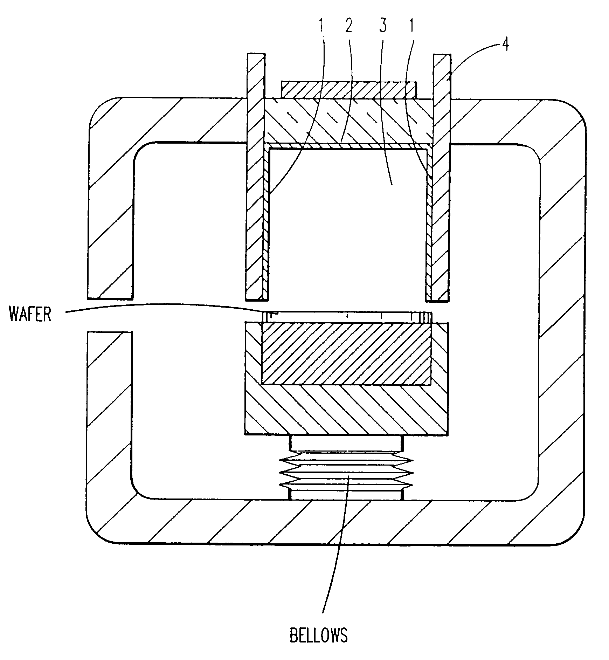

### Brief Description of the Drawing

The sole figure is a simplified cross-sectional view of a plasma reaction chamber having conductive diamond-coated surfaces in accordance with the present invention.

### Description of the Preferred Embodiment

Aluminum commonly is used as the material for constructing the chamber for housing the plasma and the semiconductor device workpiece in a reactive ion etching tool. Reactive ions from the etching plasma bombard the chamber walls as well as the intended workpiece and liberate aluminum atoms. The liberated atoms erode the chamber walls and, more objectionably, contaminate the semiconductor device. In order to avoid such erosion and contamination, the present invention contemplates forming a diamond layer on the aluminum walls of the chamber. Diamond deposition processes for aluminum substrates are known in the art and are described, for example, in U.S. patent 4,767,517, issued Aug. 30, 1988 to Akio Hiraki et al. for Process of Depositing Diamond-Like Thin Film by Cathode Sputtering and in U.S. patent 3,840,451, issued Oct. 8, 1974 to V. M. Golyanov et al. for Method of Producing an Artificial Diamond Film.

The diamond layer is desirably hard, strong and nonreactive to the reactive ion bombardment from the plasma. However, it could also be undesirably non-conductive as a coating on the chamber walls. It should be noted that the chamber walls are used as electrical ground in the reactive ion etching process. The diamond coating is made conductive, in accordance with the present invention, by the doping of proper impurities as stated in the cited U.S. patents 4,767,517 and 3,840,451. Alternatively, the deposited diamond layer can be made conductive by close control of the CVD process parameters to determine the amount of graphite interspersed with the diamond.

Using either of the above conductivity determining techniques, a resistivity of about 10¹⁶Ω-cm preferably is imparted to the diamond coating which is deposited along surfaces 1 and 2 of the figure. Other desired characteristics of the diamond coating include a thermal conductivity of about 20W/cm °K (to allow good heat transfer from the plasma 3 to the inner chamber wall 4) and a thermal expansion rate of about 0.8 x 10⁻⁶M/°K. A dielectric constant of about 5.5 and a breakdown voltage of about 10⁷ V/cm also is preferred.

## Claims

1. A reactive ion etching (RIE) apparatus comprising:
plasma etching means for providing an etching plasma for etching material off of a substrate; and
a chamber housing for containing said etching plasma, said chamber housing having surfaces surrounding said etching plasma covered with a conductive diamond layer.

2. The RIE apparatus defined in claim 1 wherein said layer has a resistivity of about 10^{16Ω} -cm.

3. The RIE apparatus defined in claim 1 wherein said layer has a thermal conductivity of about 20 W/cm°K.

4. The RIE apparatus defined in claim 1 wherein said layer has a dielectric constant of about 5.5.

5. The RIE apparatus defined in claim 1 wherein said layer has a breakdown voltage of about 10⁷ V/cm.

## Patentansprüche

1. Vorrichtung für das reaktive Ionenätzen (RIE), enthaltend:
Plasmaätzmittel zur Bereitstellung eines Ätzplasmas, um damit Material von einem Substrat wegzuätzen; und
ein Kammergehäuse, welches das Ätzplasma enthält, wobei das Kammergehäuse Oberflächen hat, die das Ätzplasma umgeben und mit einer leitenden Diamantschicht bedeckt sind.

2. RIE-Vorrichtung wie in Anspruch 1 definiert, wobei die Schicht einen spezifischen Widerstand von etwa 10¹⁶ Ωcm aufweist.

3. RIE-Vorrichtung wie in Anspruch 1 definiert, wobei die Schicht eine Wärmeleitfähigkeit von etwa 20 W/cm°K aufweist.

4. RIE-Vorrichtung wie in Anspruch 1 definiert, wobei die Schicht eine Dielektrizitätskonstante von etwa 5,5 aufweist.

5. RIE-Vorrichtung wie in Anspruch 1 definiert, wobei die Schicht eine Durchschlagspannung von etwa 10⁷ V/cm aufweist.

## Revendications

1. Appareil d'attaque par ions réactifs (RIE) comprenant :
un élément d'attaque au plasma pour fournir un plasma d'attaque pour supprimer par attaque un matériau d'un substrat; et
un bâti de chambre pour confiner ledit plasma d'attaque, ledit bâti de chambre comprenant des surfaces entourant ledit plasma d'attaque recouvertes d'une couche de diamant conductrice.

2. Appareil d'attaque par ions réactifs selon la revendication 1, dans lequel ladite couche a une résistivité d'environ 10¹⁶ ohms.cm.

3. Appareil d'attaque par ions réactifs selon la revendication 1, dans lequel ladite couche a une conductivité thermique d'environ 20 W/cm°K.

4. Appareil d'attaque par ions réactifs selon la revendication 1, dans lequel ladite couche a une constante diélectrique d'environ 5,5.

5. Appareil d'attaque par ions réactifs selon la revendication 1, dans lequel ladite couche a une tension de claquage d'environ 10⁷ V/cm.
